# EUROPEAN PATENT SPECIFICATION

(11) **EP 3 923 317 B1**
(45) Date of publication and mention of the grant of the patent: **04.11.2026**
(21) Application number: 20752103.0
(22) Date of filing: 03.02.2020
(51) Int. Cl.: H10W 40/10, H10W 40/70, H10W 42/00, H10W 76/40, H10W 90/00, H10W 72/00, H10W 72/20, H10W 72/30, H10W 72/90, H10W 74/15, H10W 76/60

(54) **ELECTRONIC APPARATUS, SEMICONDUCTOR DEVICE, INSULATING SHEET, AND METHOD FOR MANUFACTURING SEMICONDUCTOR DEVICE**
ELEKTRONISCHES GERÄT, HALBLEITERBAUELEMENT, ISOLIERSCHICHT UND VERFAHREN ZUR HERSTELLUNG EINES HALBLEITERBAUELEMENTS
APPAREIL ÉLECTRONIQUE, DISPOSITIF À SEMI-CONDUCTEUR, FEUILLE D'ISOLATION ET PROCÉDÉ DE FABRICATION DE DISPOSITIF À SEMI-CONDUCTEUR

(30) Priority: 04.02.2019 JP 2019018217
(43) Date of publication of application: 15.12.2021
(73) Proprietor: Sony Interactive Entertainment Inc., Tokyo 108-0075 (JP)
(72) Inventor: TSUCHIDA, Shinya, Tokyo 108-0075 (JP); SABELSTROM, Nils, Tokyo 108-0075 (JP); MORISHITA, Mitsuharu, Tokyo 108-0075 (JP); HIROSE, Kenji, Tokyo 108-0075 (JP); HAYASHIBARA, Masanori, Tokyo 108-0075 (JP); TAMURA, Tetsuji, Tokyo 108-0075 (JP); OONISHI, Sei, Tokyo 108-0075 (JP); SUGAWARA, Nobuyuki, Tokyo 108-0075 (JP)
(74) Representative: Gill Jennings & Every LLP
(86) International application number: PCT/JP2020/003993
(87) International publication number: WO 2020/162417

(56) References cited:
- EP-A1- 1 988 574
- JP-A- 2001 267 473
- JP-A- 2003 152 149
- JP-A- 2003 229 517
- JP-A- 2007 243 106
- JP-A- 2014 017 371
- JP-U- 3 116 877
- US-A1- 2003 085 475
- US-A1- 2011 012 255

## Description

### [Technical Field]

The present disclosure relates to a technology for improving performance of cooling a semiconductor device.

### [Background Art]

A semiconductor chip constituting a semiconductor device that functions as a Central Processing Unit (CPU), a Graphics Processing Unit (GPU), or the like is thermally connected to and cooled by a radiator such as a heat sink or a heat pipe. There are many electronic apparatuses using grease as a thermally conductive material provided between the semiconductor chip and the radiator. Previously proposed arrangements are disclosed by PTL 3, 4, 5 and 6.

### [Citation List]

### [Patent Literature]

[PTL 1] Japanese Patent Laid-Open No. 2012-69902
[PTL 2] Japanese Patent Laid-Open No. 2007-335742
[PTL 3] JP 2014 017371 A
[PTL 4] EP 1 988 574 A1
[PTL 5] US 2003/085475 A1
[PTL 6] US 2011/012255 A1

### [Summary]

### [Technical Problem]

However, when an amount of heat generated by the semiconductor chip is increased, it becomes difficult to cool the semiconductor chip sufficiently due to a thermal resistance possessed by the grease. In a semiconductor device of PTL 2, a metal that is liquefied by heat at the time of operation of the semiconductor chip is used as a thermally conductive material between the semiconductor chip and the radiator in place of the grease. The use of such a metal decreases a thermal resistance between the semiconductor chip and the radiator, and can therefore improve the performance of cooling the semiconductor chip.

In a structure using a metal having fluidity as the thermally conductive material, it is important to limit a range over which the thermally conductive material spreads even in a case where a change in attitude of the semiconductor device or vibration occurs in order to fully exert the cooling performance. In addition, when the radiator is pressed to the semiconductor chip, it is important for a pressing force to act fully on the semiconductor chip. That is, adhesion between the semiconductor chip and the radiator is also important.

### [Solution to Problem]

The invention is defined by the appended claims.
An example of an electronic apparatus proposed in the present disclosure includes a semiconductor chip, a substrate that is disposed on a lower side of the semiconductor chip and has a first region as a region in which the semiconductor chip is mounted and a second region as a region in which a conductor element including at least one of a circuit pattern and an electric part is disposed, a radiator disposed on an upper side of the semiconductor chip, and a thermally conductive material present between the radiator and the semiconductor chip. The electronic apparatus further includes a seal member surrounding the thermally conductive material and an insulating portion covering the conductor element. The thermally conductive material has electric conductivity and has fluidity at least at a time of operation of the semiconductor chip. According to this electronic apparatus, the seal member and the insulating portion can limit a range over which the thermally conductive material spreads. Incidentally, in this electronic apparatus, the insulating portion is, for example, a part obtained by curing an insulating material, a sheet formed by an insulating material, or the like.

Another example of the electronic apparatus proposed in the present disclosure includes a semiconductor chip, a substrate that is disposed on a lower side of the semiconductor chip and has a first region as a region in which the semiconductor chip is mounted and a second region as a region in which a conductor element including at least one of a circuit pattern and an electric part is disposed, a radiator disposed on an upper side of the semiconductor chip, and a thermally conductive material present between the radiator and the semiconductor chip. The electronic apparatus further includes an insulating portion covering the conductor element. The thermally conductive material has electric conductivity and has fluidity at least at a time of operation of the semiconductor chip. A distance from at least a part of an upper surface of the insulating portion to a lower surface of the radiator is larger than a distance from an upper surface of the semiconductor chip to the lower surface of the radiator. According to this electronic apparatus, a range over which the thermally conductive material spreads can be limited to a region in which the conductor element is not present. In addition, adhesion between the radiator and the semiconductor chip can be secured.

An example of a semiconductor device proposed in the present disclosure includes a semiconductor chip, a substrate that is disposed on a lower side of the semiconductor chip and has a first region as a region in which the semiconductor chip is mounted and a second region as a region in which a conductor element including at least one of a circuit pattern and an electric part is disposed, and an insulating sheet covering the conductor element. According to this semiconductor device, a range over which a thermally conductive material spreads can be limited to a region in which the conductor element is not present.

Another example of the semiconductor device proposed in the present disclosure includes a semiconductor chip, a substrate that is disposed on a lower side of the semiconductor chip and has a first region as a region in which the semiconductor chip is mounted and a second region as a region in which a conductor element including at least one of a circuit pattern and an electric part is disposed, and an insulating portion covering the conductor element. A height of at least a part of an upper surface of the insulating portion with respect to the substrate is smaller than a height of the upper surface of the semiconductor chip with respect to the substrate. According to this semiconductor device, a range over which a thermally conductive material spreads can be limited to a region in which the conductor element is not present. In addition, adhesion between a radiator and the semiconductor chip can be secured.

An insulating sheet proposed in the present disclosure is an insulating sheet for attachment to a semiconductor device including a semiconductor chip and a substrate disposed on a lower side of the semiconductor chip, the substrate having a first region as a region in which the semiconductor chip is mounted and a second region as a region in which a conductor element including at least one of a circuit pattern and an electric part is disposed. The insulating sheet includes a housing portion configured to cover the conductor element, the housing portion having a top wall located on an upper side of the conductor element and an inner wall that is located on an inside of the top wall and descends from the top wall, and an attachment target portion connected to the inner wall and located at a position lower than the top wall. According to this insulating sheet, a range over which a thermally conductive material spreads can be limited to a region in which the conductor element is not present. In addition, the insulating sheet can be attached to the substrate relatively easily even in a case where a difference in height between the conductor element and the semiconductor chip is small.

An example of a semiconductor device manufacturing method proposed in the present disclosure includes a step of preparing a substrate that is disposed on a lower side of the semiconductor chip and has a first region as a region in which the semiconductor chip is mounted and a second region as a region in which a conductor element including at least one of a circuit pattern and an electric part is disposed, and a step of covering the conductor element by an insulating portion. In the step of covering the conductor element by the insulating portion, a height of an upper surface of the insulating portion with respect to the substrate is made smaller than a height of an upper surface of the semiconductor chip with respect to the substrate. According to this method, a range over which a thermally conductive material spreads can be limited to a region in which the conductor element such as the electric part is not present. In addition, adhesion between a radiator and the semiconductor chip can be secured.

### [Brief Description of Drawings]

[FIG. 1A]

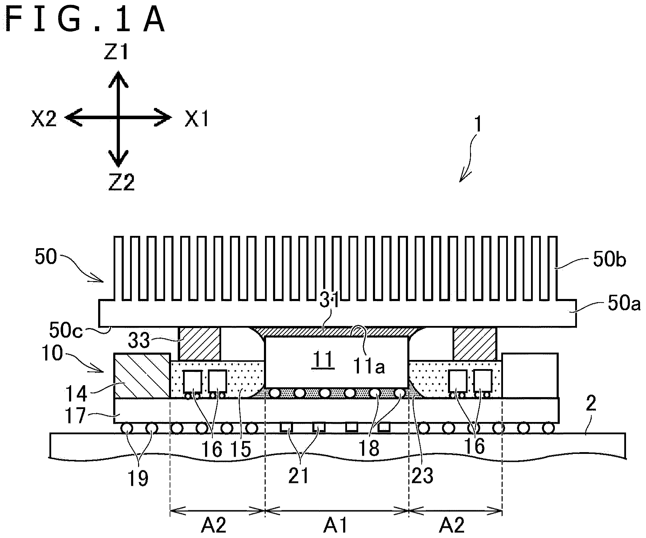

   FIG. 1A is a sectional view illustrating an example of an electronic apparatus proposed in the present disclosure.
[FIG. 1B]

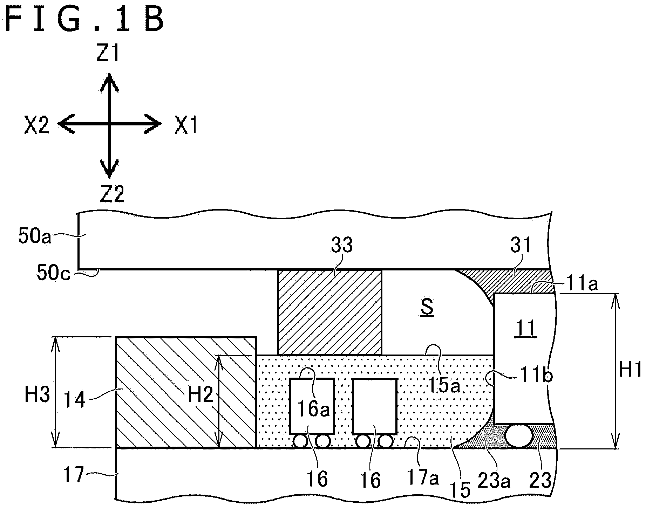

   FIG. 1B is an enlarged view of principal parts illustrated in FIG. 1A.
[FIG. 2]

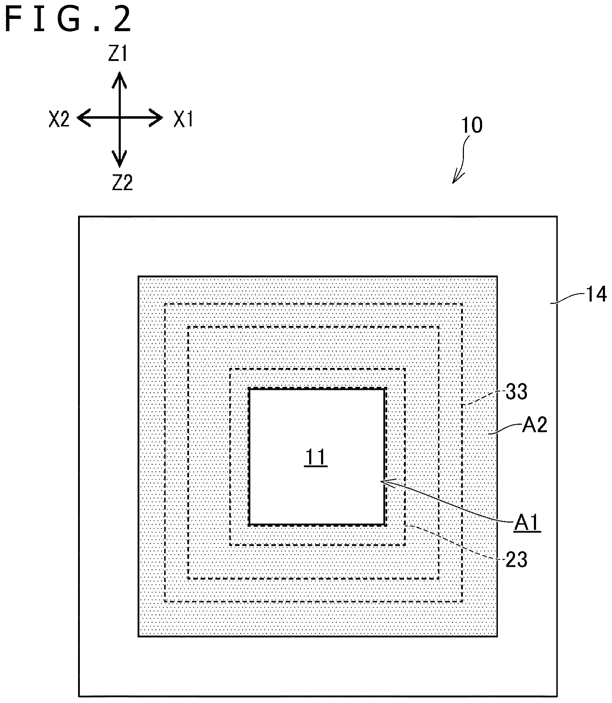

   FIG. 2 is a plan view of a semiconductor device included in an electronic apparatus.
[FIG. 3A]

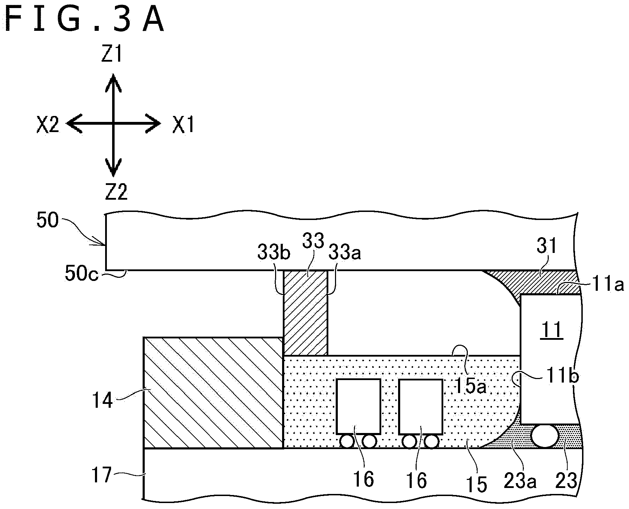

   FIG. 3A is a sectional view illustrating a modification of the position of a seal member.
[FIG. 3B]

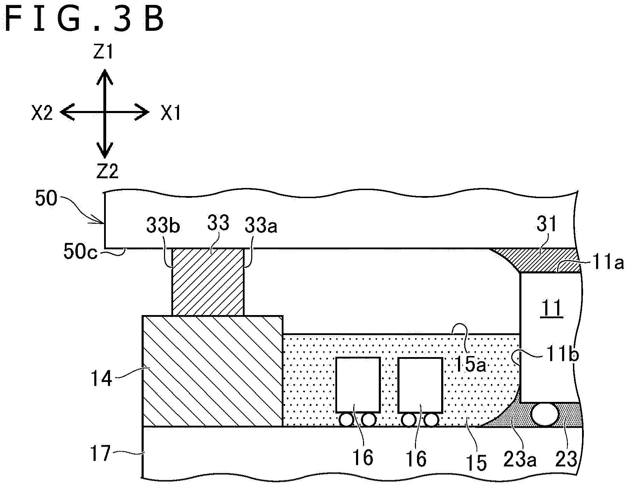

   FIG. 3B is a sectional view illustrating a modification of the position of the seal member.
[FIG. 3C]

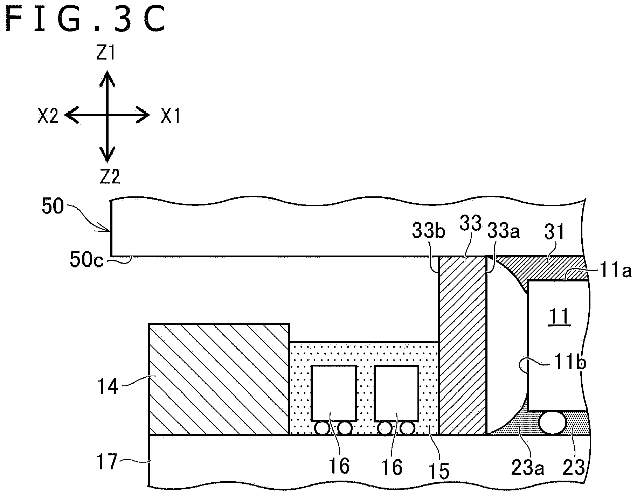

   FIG. 3C is a sectional view illustrating a modification of the position of the seal member.
[FIG. 4]

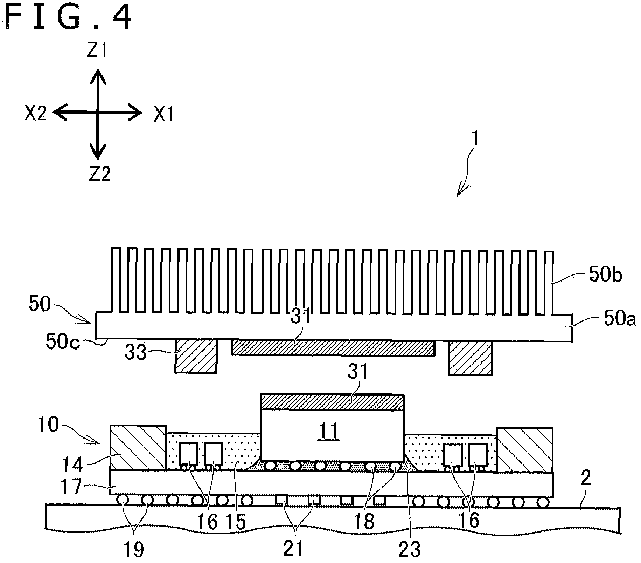

   FIG. 4 is a diagram of assistance in explaining a step of manufacturing the electronic apparatus.
[FIG. 5A]

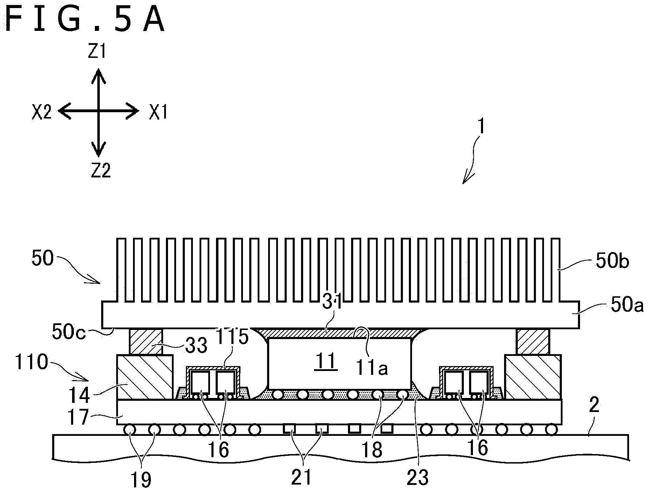

   FIG. 5A is a sectional view illustrating another example of the electronic apparatus proposed in the present disclosure.
[FIG. 5B]

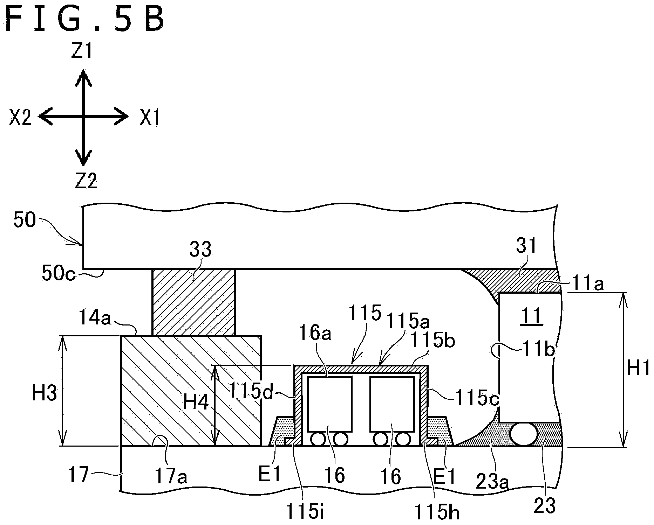

   FIG. 5B is an enlarged view of FIG. 5A.
[FIG. 6]

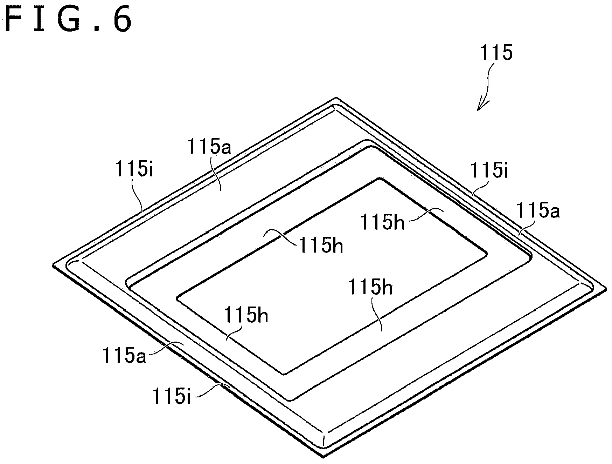

   FIG. 6 is a perspective view of an insulating sheet included in the electronic apparatus illustrated in FIG. 5A.
[FIG. 7]

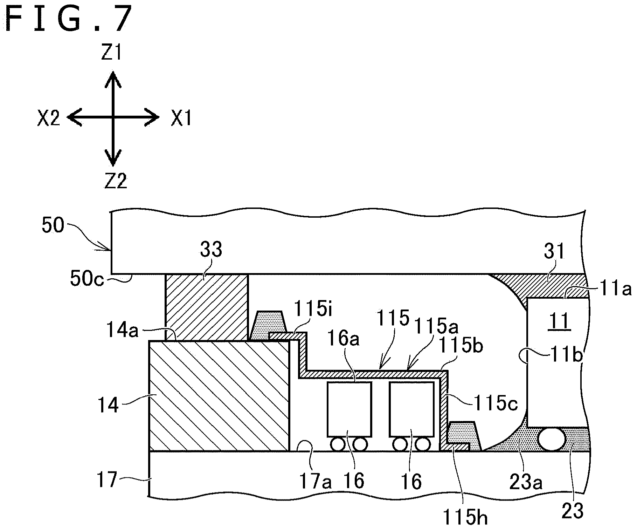

   FIG. 7 is a diagram illustrating a modification of an insulating sheet attachment structure.
[FIG. 8]

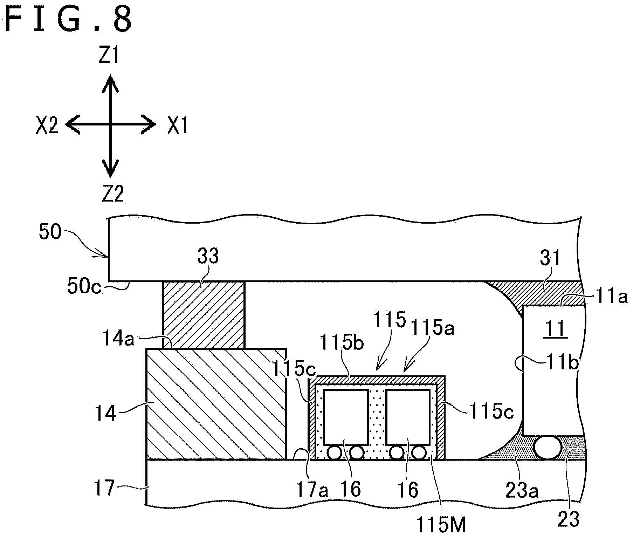

   FIG. 8 is a diagram illustrating another modification of the insulating sheet attachment structure.
[FIG. 9A]

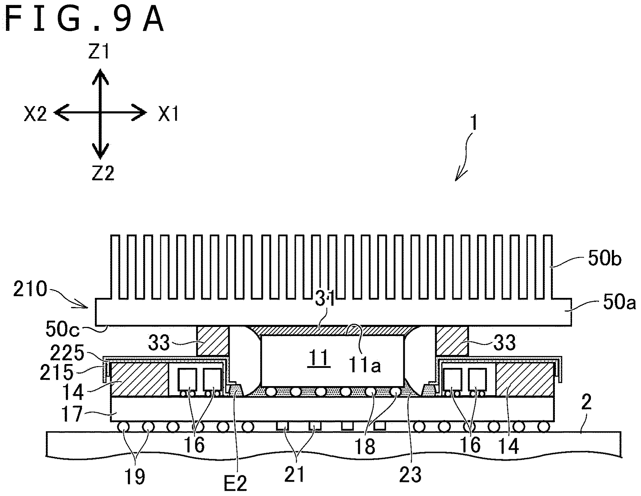

   FIG. 9A is a sectional view illustrating still another example of the electronic apparatus proposed in the present disclosure.
[FIG. 9B]

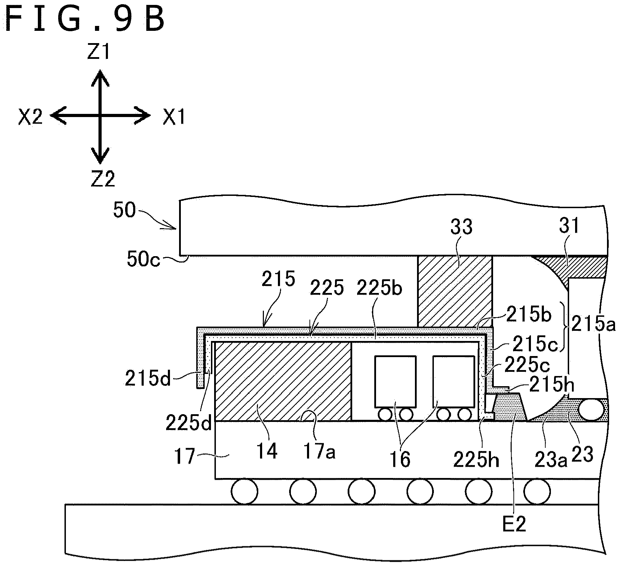

   FIG. 9B is an enlarged view of FIG. 9A.

### [Description of Embodiment]

A semiconductor device and an electronic apparatus proposed in the present disclosure will hereinafter be described. In the present specification, a semiconductor device 10 and an electronic apparatus 1 will be described as an example of the semiconductor device and the electronic apparatus proposed in the present disclosure. The electronic apparatus proposed in the present disclosure is, for example, applicable to a game machine, a development machine for executing various programs (for example, game programs) under development, and an information processing device (for example, a personal computer, a server apparatus, or a control device of a transportation vehicle) different from a game machine.

In the following description, a direction indicated by X1-X2 in FIG. 1 will be referred to as a horizontal direction, and directions indicated by Z1 and Z2 will be referred to as an upward direction and a downward direction, respectively. These directions are used to describe relative positional relations between elements (parts, members, and portions) of the electronic apparatus 1, and do not define the attitude of the electronic apparatus 1 during usage.

### [Basic Configuration]

As illustrated in FIG. 1A, the electronic apparatus 1 includes the semiconductor device 10, a circuit board 2, and a radiator 50. In description in the present specification, the circuit board 2 is disposed on the lower side of the semiconductor device 10, and the radiator 50 is disposed on the upper side of the semiconductor device 10.

The semiconductor device 10 includes a semiconductor chip 11 and a substrate (package substrate) 17 located on the lower side of the semiconductor chip 11. The semiconductor chip 11 functions as a CPU, a GPU, or the like. The semiconductor chip 11 is, for example, flip-chip mounted on an upper surface 17a (see FIG. 1B) of the substrate 17. That is, a plurality of solder bumps 18 formed on the lower surface of the semiconductor chip 11 are soldered to bumps (not illustrated) formed on the substrate 17. A gap between the semiconductor chip 11 and the substrate 17 is filled with an underfill 23. The underfill 23 is formed by a resin, for example. The underfill 23 is cured between the semiconductor chip 11 and the substrate 17. A method of mounting the semiconductor chip 11 onto the substrate 17 may be wire bonding, tape bonding, or the like.

In addition to the semiconductor chip 11, a plurality of electric parts are mounted on the upper surface 17a of the substrate 17. In the example illustrated in FIG. 1A and FIG. 1B, a plurality of capacitors 16 are mounted on the substrate 17. In the present specification, in the semiconductor device 10, a region in which the semiconductor chip 11 is disposed will be referred to as a first region A1 (see FIG. 1A and FIG. 2), and a region on the periphery of the semiconductor chip 11 in which region the plurality of electric parts such as the capacitors 16 are arranged will be referred to as a second region A2 (see FIG. 1A and FIG. 2). A circuit pattern (including through holes or vias) may be formed in the second region A2 in addition to the mounting of the capacitors 16 or in place of the mounting of the capacitors 16. A stiffener 14 to be described later is attached to the peripheral edge of the substrate 17. The second region A2 is a region between the inner surface of the stiffener 14 and the side surface of the semiconductor chip 11. An insulating portion 15 to be described later is formed in the second region A2.

The stiffener 14 is a square frame formed by a metal. The stiffener 14 is attached to the peripheral edge of the substrate 17. Usable as a material for the stiffener 14 is, for example, aluminum, copper, or the like. An adhesive or solder may be used for the attachment of the stiffener 14 to the substrate 17. The stiffener 14 can reduce a warp in the substrate 17. The first region A1 and the second region A2 are defined on the inside of the stiffener 14.

As illustrated in FIG. 1A, the substrate 17 is mounted on the circuit board 2 included in the electronic apparatus 1. A Ball Grid Array (BGA) 19, for example, is formed on the lower surface of the substrate 17. That is, a plurality of solder bumps arranged in a lattice manner are formed on the lower surface of the substrate 17. The BGA 19 is soldered to a conductor pad formed on the circuit board 2. A method of mounting the substrate 17 onto the circuit board 2 is not necessarily limited to a method using the BGA 19, but various other mounting methods may be adopted as the method of mounting the substrate 17 onto the circuit board 2. For example, a Pin Grid Array (PGA) provided with pin-shaped lead terminals or a Land Grid Array (LGA) having electrodes arranged in the shape of an array may be used. A plurality of capacitors 21 may be mounted on the lower surface of the substrate 17 in addition to the BGA 19.

The radiator 50 is, for example, a heat sink. As illustrated in FIG. 1A, the radiator 50 includes a plate-shaped heat receiving portion 50a and fins 50b. The fins 50b are, for example, formed on the upper side of the heat receiving portion 50a. A vapor chamber formed by a plate-shaped container and a hydraulic fluid contained in the container may be used as the heat receiving portion 50a. As still another example, the radiator 50 may include a heat pipe. The radiator 50 may be biased toward the semiconductor chip 11 by an elastic member (for example, a spring) not illustrated. In addition, the electronic apparatus 1 may include a cooling fan not illustrated which forms an airflow toward the radiator 50.

### [Thermally Conductive Material]

As illustrated in FIG. 1A, a lower surface 50c of the radiator 50 is opposed to an upper surface 11a of the semiconductor chip 11. A thermally conductive material 31 is disposed between the lower surface 50c of the radiator 50 and the upper surface 11a of the semiconductor chip 11. The thermally conductive material 31 is in direct contact with the lower surface 50c of the radiator 50 and the upper surface 11a of the semiconductor chip 11. The radiator 50 and the semiconductor chip 11 are thermally connected to each other by the thermally conductive material 31.

The thermally conductive material 31 is a material having fluidity. More specifically, the thermally conductive material 31 is a material having fluidity at least at the time of operation of the semiconductor chip 11. Preferably, the thermally conductive material 31 is in a liquid or paste form at least at the time of operation of the semiconductor chip 11. The thermally conductive material 31 may be a material that does not have fluidity at the time of non-operation of the semiconductor chip 11 (in other words, at room temperature (for example, 20°C)) though generating fluidity at the time of operation of the semiconductor chip 11. That is, the thermally conductive material 31 may be a material that generates fluidity by heat generated by the operation of the semiconductor chip 11. The time of non-operation of the semiconductor chip 11 is, for example, the time of manufacturing, the time of transportation, or a time during which power to the electronic apparatus is in an off state. Unlike this, the thermally conductive material 31 may be a material having fluidity also at the time of non-operation of the semiconductor chip 11. That is, the thermally conductive material 31 may be in any state such as a liquid form, a paste form, a powder form, a plate form, or a block form at the time of non-operation of the chip.

The fluidity of the thermally conductive material 31 reduces a thermal resistance between the upper surface 11a of the semiconductor chip 11 and the lower surface 50c of the radiator 50, the thermal resistance being caused by a slight warp in the upper surface 11a of the semiconductor chip 11 or microscopic unevenness of the lower surface 50c of the radiator 50. The fluidity of the thermally conductive material 31 can therefore improve the performance of cooling the semiconductor chip 11. Further, when the thermally conductive material 31 has fluidity at room temperature, the radiator 50 can be separated from the semiconductor chip 11. As a result, at the time of repairing the electronic apparatus 1, for example, repair work can be performed after the radiator 50 is removed from the semiconductor device 10. In addition, the thermally conductive material 31 is a material having electric conductivity, or in other words, a material having high thermal conductivity.

A liquid metal, which is a liquid at room temperature, for example, can be used as the thermally conductive material 31. Usable as the liquid metal are, for example, one or more kinds of low melting point metals selected from a group including Ga (melting point: 29.8°C, thermal conductivity: 40.6 W/mk), In (melting point: 156.4°C, thermal conductivity: 81.6 W/mk), and Sn (melting point: 231.97°C, thermal conductivity: 66.6 W/mk) or alloys containing the one or more kinds of low melting point metals. Concrete examples of the alloys include In-Ag, Sn-Ag-Cu, In-Sn-Bi, and the like. An electrically conductive paste may be used as another example of the thermally conductive material 31. A silver paste obtained by dispersing silver powder in a resin can be used as the electrically conductive paste.

The thermally conductive material 31 is preferably applied to an entire region of the upper surface 11a of the semiconductor chip 11. The thermally conductive material 31 may be in contact with a part of a side surface 11b (see FIG. 1B) of the semiconductor chip 11. A region in the lower surface 50c of the radiator 50 to which region the thermally conductive material 31 is applied may be larger than the semiconductor chip 11.

### [Seal Member and Insulating Portion]

Because the thermally conductive material 31 has fluidity, a range over which the thermally conductive material 31 spreads needs to be limited in order to exert cooling performance. In addition, because the thermally conductive material 31 has electric conductivity, the range over which the thermally conductive material 31 spreads needs to be limited so as to prevent the thermally conductive material 31 from touching the capacitors 16 and the circuit pattern provided in the second region A2. In addition, it is undesirable for the thermally conductive material 31 to come into contact with another part of the electronic apparatus 1 which part is located on the outside of the semiconductor device 10 (outside of the stiffener 14). Accordingly, the electronic apparatus 1 has the following structure.

### [Insulating Portion]

As illustrated in FIG. 1A, the semiconductor device 10 has the insulating portion 15 that covers conductor elements provided in the second region A2 (see FIG. 2), that is, the capacitors 16 and the circuit pattern. In the example of the semiconductor device 10, as illustrated in FIG. 1B, the insulating portion 15 is formed between the inner surface of the stiffener 14 and the side surface 11b of the semiconductor chip 11. The insulating portion 15 is formed in the whole of the second region A2 and is in contact with the inner surface of the stiffener 14 and the side surface 11b of the semiconductor chip 11. Therefore, an inner peripheral portion of the insulating portion 15 is superposed on the upper side of a peripheral portion 23a (see FIG. 1B) of the underfill 23 formed between the semiconductor chip 11 and the substrate 17. The insulating portion 15 is not formed in the first region A1. The upper surface 11a of the semiconductor chip 11 is exposed from the insulating portion 15.

The insulating portion 15 is, for example, a resin. More specifically, the insulating portion 15 is a part obtained by curing a resin in a liquid or gel form. An ultraviolet curable resin, for example, can be used as the insulating portion 15. The resin is applied so as to cover the conductor elements in the second region A2 (that is, the capacitors 16 and the circuit pattern), and is thereafter cured by receiving ultraviolet rays to form the insulating portion 15. The insulating portion 15 can prevent the thermally conductive material 31 from touching the conductor elements present in the second region A2.

As illustrated in FIG. 1B, a height H2 of an upper surface 15a of the insulating portion 15 (height from the upper surface 17a of the substrate 17) is smaller than a height H1 of the upper surface 11a of the semiconductor chip 11 (height from the upper surface 17a of the substrate 17). Because of this, a distance from the upper surface 15a of the insulating portion 15 to the lower surface 50c of the radiator 50 is larger than a distance from the upper surface 11a of the semiconductor chip 11 to the lower surface 50c of the radiator 50. Therefore, when the radiator 50 is pressed toward the semiconductor chip 11, sufficient adhesion between the radiator 50 and the semiconductor chip 11 can be secured without interference occurring between the insulating portion 15 and the lower surface 50c of the radiator 50.

As illustrated in FIG. 1B, in the example of the semiconductor device 10, the height of upper surfaces 16a of the capacitors 16 (height from the upper surface 17a of the substrate 17) is smaller than the height H1 of the upper surface 11a of the semiconductor chip 11. The insulating portion 15 preferably covers the upper surfaces 16a of the capacitors 16. In other words, the whole of the capacitors 16 is preferably covered by the insulating portion 15. This can reliably prevent the thermally conductive material 31 from touching the capacitors 16. The whole of the capacitors 16 may be buried in the insulating portion 15.

In addition, as illustrated in FIG. 1B, a height H3 of an upper surface 14a of the stiffener 14 (height from the upper surface 17a of the substrate 17) is smaller than the height H1 of the upper surface 11a of the semiconductor chip 11. The height H2 of the upper surface 15a of the insulating portion 15 is smaller than the height H3 of the upper surface 14a of the stiffener 14. Therefore, when the radiator 50 is pressed toward the semiconductor chip 11, sufficient adhesion between the radiator 50 and the semiconductor chip 11 can be secured without interference occurring between the stiffener 14 and the lower surface 50c of the radiator 50. Unlike the example illustrated in FIG. 1B, the height H2 of the upper surface 15a of the insulating portion 15 may be the same as the height H3 of the upper surface 14a of the stiffener 14.

In a case where the conductor elements such as the circuit pattern and the capacitors 16 or the like exposed to the upper surface 17a of the substrate 17 are formed only in a part of the second region A2, the insulating portion 15 may be formed only in this part of the second region A2. For example, as illustrated in FIG. 3C, the insulating portion 15 may be separated from the side surface 11b of the semiconductor chip 11. In an example illustrated in this figure, a seal member 33 to be described later is disposed between the insulating portion 15 and the side surface 11b of the semiconductor chip 11. Such an insulating portion 15 may, for example, be a part obtained by curing a resin (specifically, an ultraviolet curable resin) in a liquid or gel form which resin is supplied between this seal member 33 and the stiffener 14.

### [Seal Member]

The electronic apparatus 1 has a seal member 33 that surrounds the thermally conductive material 31 (see FIG. 1A). A square opening as viewed in plan is formed in the seal member 33, and the thermally conductive material 31 and the semiconductor chip 11 are located on the inside of the seal member 33 (see FIG. 2). As illustrated in FIG. 1B, the seal member 33 is located between the semiconductor device 10 and the lower surface 50c of the radiator 50, seals a space between the semiconductor device 10 and the lower surface 50c of the radiator 50, and retains the thermally conductive material 31 within the semiconductor device 10. The seal member 33 is separated from the peripheral edge (side surface 11b) of the semiconductor chip 11. It is therefore possible to apply the thermally conductive material 31 described above to the whole of the upper surface 11a of the semiconductor chip 11. That is, the thermally conductive material 31 can be continuously applied as far as four edge portions of the upper surface 11a.

The seal member 33 is disposed between the upper surface 15a of the insulating portion 15 and the lower surface 50c of the radiator 50, and is sandwiched by the two surfaces 15a and 50c. The seal member 33 may be attached to the lower surface 50c of the radiator 50. The seal member 33 may, for example, be bonded to the lower surface 50c of the radiator 50. Conversely, the seal member 33 may be attached to the upper surface 15a of the insulating portion 15. The seal member 33 may, for example, be bonded to the upper surface 15a of the insulating portion 15.

In addition, the seal member 33 may have a part located above the capacitors 16 covered by the insulating portion 15. That is, the seal member 33 may have a part overlapping the capacitors 16 as viewed in plan of the semiconductor device 10. The semiconductor device 10 having such a positional relation makes it possible to adopt the seal member 33 having a large width in the horizontal direction, and thereby improve a sealing property. A space S in which air is present is formed on the inside of the seal member 33.

The seal member 33 is, for example, formed by a material having a cushioning characteristic. That is, the seal member 33 is formed by a material that allows a change in the thickness of the seal member 33 in a direction in which the upper surface 11a of the semiconductor chip 11 and the lower surface 50c of the radiator 50 face each other, that is, an upward-downward direction. A material for the seal member 33 is, for example, a rubber, a sponge, a resin having a foam forming property, silicone, or the like. This can reduce a load acting on the semiconductor device 10 through the seal member 33 even in a case where the radiator 50 is pressed toward the semiconductor chip 11 by an elastic member.

The position of the seal member 33 is not limited to the example illustrated in FIG. 1B. For example, as illustrated in FIG. 3A, the seal member 33 may be located between the upper surface 15a of the insulating portion 15 and the lower surface 50c of the radiator 50 and avoid the positions of the capacitors 16. That is, the seal member 33 may be disposed so as not to overlap the capacitors 16 as viewed in plan. This can prevent a load from acting on the capacitors 16 from the radiator 50 through the seal member 33.

In still another example out of the scope of the present disclosure but useful to understand it, as illustrated in FIG. 3B, the seal member 33 may be disposed between the upper surface 14a of the stiffener 14 and the lower surface 50c of the radiator 50 and sandwiched by the two surfaces 14a and 50a. The stiffener 14 is formed by a metal and has higher stiffness than the insulating portion 15. Because the seal member 33 is pressed against the stiffener 14 having high stiffness, contact pressure between the seal member 33 and the stiffener 14 can be enhanced. As a result, the sealing property of the seal member 33 can be improved.

As described above, the insulating portion 15 may be formed at the position of the capacitors 16 and separated from the side surface 11b of the semiconductor chip 11. In this case, as illustrated in FIG. 3C, the seal member 33 may be located on the inside of the insulating portion 15. Then, the seal member 33 may be disposed between the upper surface 17a of the substrate 17 and the lower surface 50c of the radiator 50 and sandwiched by the two surfaces 17a and 50c.

That is, it suffices for an inner peripheral surface 33a of the seal member 33 (surface surrounding the semiconductor chip 11) to be located outward of the outer edge of the semiconductor chip 11 and not to coincide with the semiconductor chip 11. It suffices for an outer peripheral surface 33b of the seal member 11 (surface facing an opposite side from the inner peripheral surface 33a) to be located inward of the outer edge of the semiconductor device 10 (outer edge of the stiffener 14 in the example of the semiconductor device 10).

### [Manufacturing Method]

An example of a method of manufacturing the electronic apparatus 1 and the semiconductor device 10 will be described.

First, the semiconductor chip 11, the capacitors 16, and the stiffener 14 are mounted on the substrate 17. The underfill 23 is filled between the semiconductor chip 11 and the substrate 17. An ultraviolet curable resin in a liquid or gel form is supplied to the peripheries of the capacitors 16. That is, the ultraviolet curable resin is accumulated between the stiffener 14 and the semiconductor chip 11. An amount of resin is such that the upper surfaces 16a of the capacitors 16 are buried in the resin. The resin is cured by irradiating the resin with ultraviolet rays. The insulating portion 15 is thereby obtained. Incidentally, in a case of manufacturing a structure in which the insulating portion 15 is formed between the seal member 33 and the stiffener 14 as illustrated in FIG. 3C, the insulating portion 15 can be formed by supplying an ultraviolet curable resin in a liquid or gel form between the seal member 33 and the stiffener 14 after the seal member 33 is attached to the substrate 17.

Next, as illustrated in FIG. 4, the thermally conductive material 31 is applied to the upper surface 11a of the semiconductor chip 11 and the lower surface 50c of the radiator 50. It is preferable to spread the thermally conductive material 31 over the whole of the upper surface 11a of the semiconductor chip 11 by using the fluidity of the thermally conductive material 31. In addition, it is preferable to spread the thermally conductive material 31 over the whole of a region corresponding to the semiconductor chip 11 in the lower surface 50c of the radiator 50. The region on the radiator 50 to which region the thermally conductive material 31 is applied is preferably larger than the size of the semiconductor chip 11.

In addition, the seal member 33 is affixed to the lower surface 50c of the radiator 50. Then, the radiator 50 is attached to the semiconductor chip 11. The radiator 50 is pressed to the semiconductor chip 11 by using an elastic member such as a spring. Consequently, the lower surface 50c of the radiator 50 closely adheres to the upper surface 11a of the semiconductor chip 11.

Incidentally, in a method of applying the thermally conductive material 31 to only one of the upper surface 11a of the semiconductor chip 11 and the lower surface 50c of the radiator 50, the thermally conductive material 31 does not readily spread on the other surface when the radiator 50 is attached to the semiconductor chip 11, and thus a thermal resistance between the semiconductor chip 11 and the radiator 50 becomes larger. Such a problem can be solved by applying the thermally conductive material 31 to the upper surface 11a of the semiconductor chip 11 and the lower surface 50c of the radiator 50 as illustrated in FIG. 4.

### [Modifications]

FIG. 5A is a sectional view illustrating a modification of the electronic apparatus 1. FIG. 5B is an enlarged view of FIG. 5A. In these figures, the electronic apparatus 1 has a semiconductor device 110 as a modification of the semiconductor device 10. In the figures, the same parts as the parts or members described thus far are identified by the same reference numerals.

The semiconductor device 110 has an insulating sheet 115 (see FIG. 5A) as an insulating portion that covers conductor elements such as the capacitors 16 and the circuit pattern or the like. The insulating sheet 115 is a sheet formed by a resin. Usable as a material for the insulating sheet 115 is, for example, an engineering plastic such as polycarbonate or polyamide. FIG. 6 is a perspective view of the insulating sheet 115. FIG. 5A and FIG. 5B illustrate the insulating sheet 115 reduced in width in a left-right direction as compared with the insulating sheet 115 illustrated in FIG. 6.

As illustrated in FIG. 5B, the insulating sheet 115 has a housing portion 115a. The capacitors 16 are arranged within the housing portion 115a (space defined by the housing portion 115a and the upper surface 17a of the substrate 17). The housing portion 115a has a top wall 115b, an inner wall 115c, and an outer wall 115d. The top wall 115b is located on the upper side of the capacitors 16. The inner wall 115c is located on the inside of the capacitors 16 (that is, located nearer the center of the semiconductor device 10 than the capacitors 16), and descends from the top wall 115b toward the substrate 17. The outer wall 115d is located on the outside of the capacitors 16 and descends from the top wall 115b toward the substrate 17. Hence, a space in which the capacitors 16 are arranged is formed within the housing portion 115a.

### [Height of Housing Portion]

As illustrated in FIG. 5B, a height H4 of a highest part of the upper surface of the insulating sheet 115 (highest part of the upper surface of the top wall 115b) is smaller than the height H1 of the upper surface 11a of the semiconductor chip 11. Because of this, a distance from the upper surface of the insulating sheet 115 to the lower surface 50c of the radiator 50 is larger than a distance from the upper surface 11a of the semiconductor chip 11 to the lower surface 50c of the radiator 50. Therefore, when the radiator 50 is pressed toward the semiconductor chip 11, sufficient adhesion between the radiator 50 and the semiconductor chip 11 can be secured without interference occurring between the insulating sheet 115 and the lower surface 50c of the radiator 50.

As illustrated in FIG. 5B, the height H3 of the upper surface 14a of the stiffener 14 is smaller than the height H1 of the upper surface 11a of the semiconductor chip 11. The height H4 of the upper surface of the insulating sheet 115 is smaller than the height H3 of the upper surface 14a of the stiffener 14. When the radiator 50 is pressed toward the semiconductor chip 11, sufficient adhesion between the radiator 50 and the semiconductor chip 11 can be secured without interference occurring between the stiffener 14 and the lower surface 50c of the radiator 50. Unlike the example illustrated in FIG. 5B, the height H4 of the upper surface of the insulating sheet 115 may be the same as the height H3 of the upper surface 14a of the stiffener 14.

Incidentally, a metallic plate having a size adapted to the size of the semiconductor chip 11 may be welded to the lower surface 50c of the radiator 50. In this case, the height H4 of the upper surface of the insulating sheet 115 may be higher than the height H1 of the upper surface 11a of the semiconductor chip 11. According to this structure, the distance from the upper surface of the insulating sheet 115 to the lower surface 50c of the radiator 50 can be made larger than the distance from the upper surface 11a of the semiconductor chip 11 to the lower surface of the radiator 50 (lower surface of the metallic plate) by adjusting the thickness of the metallic plate. As a result, sufficient adhesion between the radiator 50 and the semiconductor chip 11 can be secured without interference occurring between the insulating sheet 115 and the lower surface 50c of the radiator 50.

### [Attachment Target Portion]

As illustrated in FIG. 5B, the insulating sheet 115 is attached to the semiconductor device 110. In an example, the insulating sheet 115 has attachment target portions 115h and 115i that constitute edges of the housing portion 115a and are attached to the substrate 17. The attachment target portions 115h and 115i are attached to the substrate 17 by an adhesive E1. An ultraviolet curable resin, for example, can be used as the adhesive E1.

As illustrated in FIG. 5B, the inner attachment target portion 115h is connected to a lower end of the inner wall 115c. The attachment target portion 115h, for example, extends in the horizontal direction from a lower edge of the inner wall 115c, and is disposed along the substrate 17. Then, the attachment target portion 115h is located between the capacitors 16 and the side surface 11b of the semiconductor chip 11. The position of the attachment target portion 115h is lower than the top wall 115b of the housing portion 115a. This shape of the insulating sheet 115 facilitates work for insulating the capacitors 16 from the thermally conductive material 31. That is, the structure illustrated in FIG. 1A presents a problem of a difficulty in managing a height to which to inject a resin so as not to exceed the upper surface 15a of the insulating portion 15 in a case where a difference between the height of the upper surfaces 16a of the capacitors 16 and the height of the upper surface 11a of the semiconductor chip 11 is small. On the other hand, the shape of the insulating sheet 115 having the attachment target portion 115h at a position lower than the top wall 115b makes it possible to attach the insulating sheet 115 to the semiconductor device 10 easily even when the difference between the height of the upper surfaces 16a of the capacitors 16 and the height of the upper surface 11a of the semiconductor chip 11 is small. In addition, the attachment target portion 115h extends in a direction along the top surface of the substrate 17. A strength of attachment of the attachment target portion 115h to the substrate 17 can therefore be increased. Incidentally, the attachment target portion 115h may not extend in the direction along the top surface of the substrate 17. In this case, the lower edge of the inner wall 115c may be bonded to the substrate 17, and function as the attachment target portion 115h.

As illustrated in FIG. 5B, the outer attachment target portion 115i is connected to a lower edge of the outer wall 115d. The attachment target portion 115i, for example, extends in the horizontal direction from the lower edge of the outer wall 115d, and is disposed along the substrate 17. The position of the attachment target portion 115i is also lower than the top wall 115b. This shape of the insulating sheet 115 facilitates work for insulating the capacitors 16 from the thermally conductive material 31. That is, the structure illustrated in FIG. 1A has a problem of a difficulty in managing a height to which to inject a resin so as not to exceed the upper surface 15a of the insulating portion 15 in a case where a difference between the height of the upper surfaces 16a of the capacitors 16 and the height of the upper surface 14a of the stiffener 14 is small. On the other hand, the shape of the insulating sheet 115 having the attachment target portion 115i at a position lower than the top wall 115b makes it possible to attach the insulating sheet 115 to the semiconductor device 10 easily even when the difference between the height of the upper surfaces 16a of the capacitors 16 and the height of the upper surface 14a of the stiffener 14 is small. In addition, the attachment target portion 115i extends in the direction along the top surface of the substrate 17. A strength of attachment of the attachment target portion 115i to the substrate 17 can therefore be increased. Incidentally, the attachment target portion 115i may not extend in the direction along the top surface of the substrate 17. In this case, the lower edge of the outer wall 115d may be bonded to the substrate 17, and function as the attachment target portion 115i.

In the structure illustrated in FIG. 5B, the inner attachment target portion 115h is in direct contact with the upper surface 17a of the substrate 17. However, the attachment target portion 115h may be indirectly attached to the substrate 17. For example, the attachment target portion 115h may be disposed on the upper side of the peripheral portion 23a of the underfill 23 and bonded to the underfill 23. As still another example, the attachment target portion 115h may be formed on the lower side of the underfill 23, and attached to the upper surface 17a of the substrate 17 by the underfill 23. This structure can reduce work processes for bonding the attachment target portion 115h.

The attachment target portions 115h and 115i are provided to the whole of edges of the housing portion 115a, and the inside of the housing portion 115a is sealed. As illustrated in FIG. 6, the insulating sheet 115 is, for example, of a rectangular shape in which an opening for disposing the semiconductor chip 11 is formed on the inside. The insulating sheet 115, for example, has four housing portions 115a along four respective side surfaces 11b of the semiconductor chip 11. The insulating sheet 115 has attachment target portions 115h along the whole of inner peripheral edges thereof and has attachment target portions 115i along the whole of outer peripheral edges thereof. Incidentally, the positions of the attachment target portions 115h and 115i are not limited to this. For example, an edge of the insulating sheet 115 may not be attached to the substrate 17 at a position where insulation is not necessary.

The shape of the insulating sheet 115 is not limited to the example illustrated in FIG. 6. For example, in a case where electric parts such as the capacitors 16 are present only in one direction or two directions with respect to the semiconductor chip 11, the insulating sheet 115 may not have the shape surrounding the semiconductor chip 11. For example, the insulating sheet 115 may be present only on one or two sides of the right side, left side, front side, and rear side of the semiconductor chip 11.

In the structure illustrated in FIG. 5B, the outer attachment target portion 115i is in direct contact with the upper surface 17a of the substrate 17. However, the attachment target portion 115i may be indirectly attached to the substrate 17. For example, as illustrated in FIG. 7, the attachment target portion 115i may be located on the upper surface 14a of the stiffener 14. Then, the attachment target portion 115i may be bonded to the upper surface 14a. In this case, the position of the attachment target portion 115i is preferably lower than the upper surface 11a of the semiconductor chip 11. This can secure adhesion between the radiator 50 and the semiconductor chip 11 because the attachment target portion 115i does not interfere with the radiator 50 when the radiator 50 is pressed to the semiconductor chip 11.

In yet another example, the insulating sheet 115 may not have the attachment target portions 115i and 115h. For example, as illustrated in FIG. 8, an insulating material may be filled into the housing portion 115a of the insulating sheet 115. The insulating material 115M may be a material functioning as an adhesive (for example, an ultraviolet curable resin). Then, the insulating sheet 115 is attached to the substrate 17 by the insulating material 115M.

### [Seal Member]

In the examples illustrated in FIG. 5A, FIG. 7, and FIG. 8, out of the scope of the present disclosure but useful to understand it, the seal member 33 is disposed between the upper surface 14a of the stiffener 14 and the lower surface 50c of the radiator 50 and is sandwiched by the two surfaces 14a and 50c. The stiffener 14 is formed by a metal and has higher stiffness than the insulating sheet 115. Because the seal member 33 is pressed against the stiffener 14 having high stiffness, contact pressure between the seal member 33 and the stiffener 14 can be enhanced. As a result, the sealing property of the seal member 33 can be improved.

### [Manufacturing Method]

An example of a method of manufacturing the semiconductor device 110 and the electronic apparatus 1 including the semiconductor device 110 will be described. First, the semiconductor chip 11, the capacitors 16, and the stiffener 14 are mounted on the substrate 17. The underfill 23 is filled between the semiconductor chip 11 and the substrate 17. Next, the capacitors 16 are covered by the insulating sheet 115. Then, an adhesive is applied to the attachment target portions 115h and 115i and is cured. The inside of the housing portion 115a is thereby sealed. An ultraviolet curable resin can be used as the adhesive. The following processes may be the same as processes for manufacturing the semiconductor device 10 and the electronic apparatus 1 including the semiconductor device 10.

### [Further Modification]

FIG. 9A is a sectional view illustrating still another modification of the electronic apparatus 1. FIG. 9B is an enlarged view of FIG. 9A. In these figures, the electronic apparatus 1 has a semiconductor device 210 as a modification of the semiconductor device 10. In the figures, the same parts as the parts or members described thus far are identified by the same reference numerals.

The semiconductor device 210 has an insulating sheet 215 (see FIG. 5A) as an insulating portion that covers conductor elements such as the capacitors 16 and the circuit pattern or the like. The insulating sheet 215 is a sheet formed by a resin. Usable as a material for the insulating sheet 215 is, for example, an engineering plastic such as polycarbonate or polyamide as in the insulating sheet 115 described above.

### [Liquid Gasket]

As illustrated in FIG. 9B, the insulating sheet 215 has a top wall 215b located on the upper side of the capacitors 16 and an inner wall 215c located on the inside of the capacitors 16. The top wall 215b and the inner wall 215c constitute a housing portion 215a that houses conductor elements such as the capacitors 16. The insulating sheet 215 is attached to the substrate 17 by a liquid gasket E2. Specifically, an attachment target portion 215h is formed at a lower end of the inner wall 215c, and the attachment target portion 215h is attached by the liquid gasket E2.

The liquid gasket has fluidity at room temperature. The liquid gasket dries or becomes uniform after a certain time from application thereof to a bonding surface, and consequently forms an elastic or adhesive thin layer. Materials for the liquid gasket include, for example, a phenol type, a modified ester type, a silicone type, an acrylic type, and the like. The use of such a liquid gasket can ensure a high sealing property between the attachment target portion 215h of the insulating sheet 215 and the substrate 17.

The attachment target portion 215h formed at a lower edge of the inner wall 215c is bent with respect to the inner wall 215c and is along the upper surface 17a of the substrate 17. The liquid gasket E2 is, for example, disposed between the upper surface 17a of the substrate 17 and the attachment target portion 215h. This can prevent the liquid gasket E2 from being mounted on the upper side of the semiconductor chip 11 in a process of assembling the semiconductor device 210, and consequently affecting thermal conductivity between the semiconductor chip 11 and the radiator 50.

### [Double Insulating Sheet]

As illustrated in FIG. 9B, the semiconductor device 210 further includes an insulating sheet 225 as a sheet for covering conductor elements such as the capacitors 16 and the circuit pattern or the like. The insulating sheet 225 is disposed on the lower side of the insulating sheet 215. The two sheets 215 and 225 are superposed on each other. (In the following description, the insulating sheet 215 will be referred to as an upper sheet, and the insulating sheet 225 will be referred to as a lower sheet.) The lower sheet 225 is also attached to the substrate 17. Specifically, the lower sheet 225 also has an inner wall 225c on the inside of the capacitors 16, and an attachment target portion 225h formed at a lower edge of the inner wall 225c is attached to the substrate 17.

A space housing conductor elements such as the capacitors 16 and the circuit pattern or the like is formed between the lower sheet 225 and the substrate 17. Hence, this space is partitioned from a space in which the thermally conductive material 31 is present by the double sheet. That is, the upper sheet 215 forms a space (inside of the housing portion 215a) partitioned from the space in which the thermally conductive material 31 is present, and the lower sheet 225 forms, within the housing portion 215a, a space partitioned from a space outside the lower sheet 225.

The lower sheet 225 is attached to the substrate 17 by a material different from the liquid gasket. The attachment target portion 225h of the lower sheet 225 is bent with respect to the inner wall 225c and is along the upper surface 17a of the substrate 17. The lower sheet 225 is, for example, attached to the substrate 17 by an adhesive tape (tape having both surfaces coated with an adhesive) disposed between the attachment target portion 225h and the substrate 17. A method of attaching the lower sheet 225 to the substrate 17 is not limited to the method using the adhesive tape. For example, the attachment target portion 215h of the lower sheet 225 may be attached by an adhesive applied to the substrate 17.

As described above, the thermally conductive material 31 having fluidity is disposed between the lower surface 50c of the radiator 50 and the upper surface 11a of the semiconductor chip 11. Because the thermally conductive material 31 has fluidity, it is possible that the thermally conductive material 31 comes out from between the lower surface 50c of the radiator 50 and the upper surface 11a of the semiconductor chip 11 and adheres to the liquid gasket E2. In a case where the radiator 50 and the upper sheet 215 need to be removed in order to repair the electronic apparatus or replace a faulty part, caution is necessary in handling so as to prevent the liquid gasket E2 to which the thermally conductive material 31 adheres from scattering. In the semiconductor device 210, the lower sheet 225 is disposed on the lower side of the upper sheet 215, and further covers the capacitors 16 within the housing portion 215a. Thus, even when the liquid gasket E2 scatters at the time of removing the radiator 50 and the upper sheet 215, a range over which the liquid gasket E2 scatters can be limited to a region in which the capacitors 16 are not present.

The lower sheet 225 and the upper sheet 215 may be formed by different materials. For example, the lower sheet 225 may be formed by a material having lower stiffness than the upper sheet 215. In addition, in the example of the semiconductor device 210, the lower sheet 225 is a sheet thinner than the upper sheet 215. An example of a material for the lower sheet 225 is polyethylene terephthalate. The lower sheet 225 may have flexibility. This can reduce a cost increase due to the lower sheet 225.

In the example illustrated in FIG. 9B, the attachment target portion 225h of the lower sheet 225 is located below the attachment target portion 215h of the upper sheet 215, and partly overlaps the attachment target portion 215h of the upper sheet 215 as viewed in plan. A part of the liquid gasket E2 is disposed on the upper side of the attachment target portion 225h of the lower sheet 225. The relation between the two attachment target portions 215h and 225h is not limited to the example illustrated in the figure. The attachment target portion 225h of the lower sheet 225 may be separated from the attachment target portion 215h of the upper sheet 215 in the horizontal direction.

The semiconductor device 210 has a sealant 33 formed by a material having a cushioning characteristic. In the example illustrated in FIG. 9A and FIG. 9B, the sealant 33 is located above the capacitors 16, and is sandwiched by the upper sheet 215 and the lower surface 50c of the radiator 50. The sealant 33 is disposed along an inner edge of the top wall 215b of the upper sheet 215. The position of the sealant 33 is not limited to the example illustrated in this figure, but may be located above the stiffener 14, for example.

In the example illustrated in FIG. 9A and FIG. 9B, the sheets 215 and 225 extend outward in the horizontal direction beyond the position of the sealant 33, and respectively have top walls 215b and 225b that cover the capacitors 16 and the stiffener 14. The sheets 215 and 225 respectively have outer walls 215d and 225d that descend from outer edges of the top walls 215b and 225b and cover the stiffener 14. The outer walls 215d and 225d are neither attached to the stiffener 14 nor attached to the substrate 17. This can reduce work necessary for attachment of the sheets 215 and 225 to the substrate 17.

Unlike this, the outer walls 215d and 225d may be attached to the stiffener 14 or the substrate 17. For example, the outer wall 215d of the upper sheet 215 may be attached to the substrate 17 by a liquid gasket, and the outer wall 225d of the lower sheet 225 may be attached to the substrate 17 or the stiffener 14 by means different from the liquid gasket (for example, an adhesive or a double-faced sheet).

The structures of the sheets 215 and 225 are not limited to the example illustrated in these figures. For example, as in the example illustrated in FIG. 5B, the sheets 215 and 225 may have an outer wall located between the stiffener 14 and the capacitors 16. Then, a lower edge (attachment target portion) of the outer wall may be attached to the substrate 17. In this case, a lower edge (attachment target portion) of the outer wall of the upper sheet 215 may be attached to the substrate 17 by a liquid gasket, and a lower edge (attachment target portion) of the outer wall of the lower sheet 225 may be attached to the substrate 17 by means different from the liquid gasket (for example, an adhesive or a double-faced sheet).

### [Manufacturing Method]

An example of a method of manufacturing the semiconductor device 210 and the electronic apparatus 1 including the semiconductor device 210 will be described. First, the semiconductor chip 11, the capacitors 16, and the stiffener 14 are mounted on the substrate 17. The underfill 23 is filled between the semiconductor chip 11 and the substrate 17. Next, the capacitors 16 are covered by the insulating sheet (lower sheet) 225. Then, the attachment target portion 225h is attached to the substrate 17 by an adhesive sheet. Next, the liquid gasket E2 is applied onto the substrate 17, and thereafter the lower sheet 225 is covered by the insulating sheet (upper sheet) 215. Then, the attachment target portion 215h of the upper sheet 215 is attached to the substrate 17 by the liquid gasket. The following processes may be the same as processes for manufacturing the semiconductor device 10 and the electronic apparatus 1 including the semiconductor device 10.

### [Summary]

In the electronic apparatus 1 described above, the thermally conductive material 31 is disposed between the radiator 50 and the semiconductor chip 11. The thermally conductive material 31 has electric conductivity and has fluidity at least at the time of operation of the semiconductor chip 11. The seal member 33 surrounds the thermally conductive material 31, and conductor elements such as a circuit pattern and electric parts or the like are covered by an insulating portion (the insulating portion 15 or the insulating sheets 115, 215, and 225). According to this structure, the seal member 33 and the insulating portion can limit a range over which the thermally conductive material 31 spreads.

In addition, in the electronic apparatus 1, the thermally conductive material 31 is disposed between the radiator 50 and the semiconductor chip 11. The thermally conductive material 31 has electric conductivity and has fluidity at least at the time of operation of the semiconductor chip 11. The conductor elements such as the circuit pattern and the electric parts or the like are covered by an insulating portion (the insulating portion 15 or the insulating sheets 115, 215, and 225). A distance from at least a part of the upper surface of the insulating portion to the lower surface 50c of the radiator 50 is larger than a distance from the upper surface 11a of the semiconductor chip 11 to the lower surface 50c of the radiator 50. According to this structure, the range over which the thermally conductive material spreads can be limited to a region in which the conductor elements such as the electric parts are not present. In addition, adhesion between the radiator and the semiconductor chip can be secured.

The semiconductor devices 110 and 210 have the insulating sheets 115, 215, and 225 that cover the conductor elements such as the circuit pattern and the electric parts or the like. According to the semiconductor devices 110 and 210, the range over which the thermally conductive material 31 spreads can be limited to the region in which the conductor elements are not present.

The semiconductor devices 10, 110, and 210 have an insulating portion (the insulating portion 15 or the insulating sheets 115, 215, and 225) that covers the conductor elements such as the circuit pattern and the electric parts or the like. The height of at least a part of the upper surface of the insulating portion with respect to the substrate 17 is smaller than the height of the upper surface 11a of the semiconductor chip 11 with respect to the substrate 17. According to this structure, adhesion between the radiator 50 and the semiconductor chip 11 can be secured while the range over which the thermally conductive material 31 spreads is limited to the region in which the conductor elements such as the electric parts are not present.

The insulating sheets 115 and 215 include the housing portions 115a and 215a having the top walls 115b and 215b located on the upper side of the conductor elements and the inner walls 115c and 215c located on the inside of the top walls 115b and 215b and descending from the top walls 115b and 215b. In addition, the insulating sheets 115 and 215 include the attachment target portions 115h and 215h connected to the inner walls 115c and 215c and located at a position lower than the top walls 115b and 215b. According to the insulating sheets 115 and 215, the range over which the thermally conductive material 31 spreads can be limited to the region in which the conductor elements are not present. In addition, even in a case where a difference in height between the conductor elements (for example, the capacitors 16) and the semiconductor chip 11 is small, the insulating sheets 115 and 215 can be attached to the substrate relatively easily.

An example of a method of manufacturing the semiconductor devices 10, 110, and 210 includes a process of covering the conductor elements such as the circuit pattern and the electric parts or the like by the insulating portion (the insulating portion 15 or the insulating sheets 115, 215, and 225). In the process of covering the conductor elements by the insulating portion, the height of the upper surface of the insulating portion with respect to the substrate 17 is smaller than the height of the upper surface 11a of the semiconductor chip 11 with respect to the substrate 17. According to this method, the range over which the thermally conductive material 31 spreads can be limited to the region in which the conductor elements such as the electric parts are not present. In addition, adhesion between the radiator 50 and the semiconductor chip 11 can be secured.

## Claims

1. An electronic apparatus (1) comprising:
a semiconductor chip (11);
a substrate (17) that is disposed on a lower side of the semiconductor chip and has a first region (A1) as a region in which the semiconductor chip is mounted and a second region (A2) as a region in which a conductor element including at least one of a circuit pattern and an electric part (16) is disposed;
a radiator (50) disposed on an upper side (11a) of the semiconductor chip;
a thermally conductive material (31) present between the radiator and the semiconductor chip;
a seal member (33) surrounding the thermally conductive material; and
an insulating portion (15, 115, 215) covering the conductor element, wherein
the thermally conductive material has electric conductivity and
has fluidity at least at a time of operation of the semiconductor chip, and
the seal member is sandwiched between an upper surface (15a) of the insulating portion and a lower surface (50c) of the radiator,
wherein an inner peripheral surface of the seal member faces the semiconductor chip, and an outer peripheral surface of the seal member is located within an inner side of an outer peripheral surface of the radiator.

2. The electronic apparatus according to claim 1, further comprising:
a stiffener (14) attached to the substrate, wherein
the insulating portion covers the stiffener, and
the seal member is located between an upper surface (14a) of the stiffener and the lower surface of the radiator.

3. The electronic apparatus according to claim 1, wherein
the insulating portion is a sheet (115, 215) that covers the conductor element.

4. The electronic apparatus according to claim 3, wherein
the insulating portion includes a first sheet (215) and a second sheet (225) that cover the conductor element, and the second sheet is disposed on a lower side of the first sheet.

5. The electronic apparatus according to claim 4, wherein
a material (E2) that attaches the first sheet to the substrate and a material (E1) that attaches the second sheet to the substrate are different from each other.

6. The electronic apparatus according to claim 1 or 3, wherein
a distance from at least a part of an upper surface of the insulating portion to a lower surface of the radiator is larger than a distance from an upper surface of the semiconductor chip to the lower surface of the radiator.

7. The electronic apparatus according to claim 1 or 3, wherein an upper surface (16a) of the electric part disposed in the second region is covered by the insulating portion.

8. The electronic apparatus according to claim 1 or 3, further comprising:
a stiffener (14) attached to the substrate, wherein
a height (H2) of the at least a part of the upper surface of the insulating portion with respect to the substrate is equal to or smaller than a height (H3) of an upper surface (14a) of the stiffener with respect to the substrate.

9. The semiconductor device according to claim 3, wherein
the insulating sheet has a top wall (115b) located on an upper side (16a) of the conductor element and a first attachment target portion (115h) located between the conductor element and
the semiconductor chip and directly or indirectly attached to the substrate, and
a position of the first attachment target portion is lower than the top wall.

10. The electronic apparatus according to claim 1, wherein
the seal member is formed by a material that allows a change in thickness of the seal member in an upward-downward direction.

11. The electronic apparatus according to claim 1, wherein
the seal member is formed by a material that is different to that of the radiator.

12. An insulating sheet (115, 215) for attachment to the electronic apparatus of claim 1 as the insulating portion, the insulating sheet comprising:
an opening formed in a central portion as viewed in plan, the semiconductor chip being able to be disposed in the opening;
a housing portion (115a, 215a) for covering the conductor element, the housing portion having a top wall (115b, 215b) located on an upper side (16a) of the conductor element and an inner wall (115c, 215c) that is located on an inside of the top wall and descends from the top wall; and
an attachment target portion (115h, 115i) located at a position lower than the top wall and constituting an edge portion of the housing portion.

13. A semiconductor device manufacturing method comprising:
a step of preparing a substrate (17) that has a first region (A1) as a region for mounting a semiconductor chip (11) and a second region (A2) as a region in which a conductor element including at least one of a circuit pattern and an electric part (16) is disposed;
a step of covering an upper side of the conductor element by an insulating portion (15, 115, 215);
a step of disposing a seal member (33) surrounding the first region on an upper surface of the insulating portion; and
a step of disposing a radiator (50) on an upper side (11a) of the semiconductor chip;
wherein the seal member is sandwiched between an upper surface (15a) of the insulating portion and a lower surface (50c) of the radiator, and
wherein an inner peripheral surface of the seal member faces the semiconductor chip, and an outer peripheral surface of the seal member is located within an inner side of an outer peripheral surface of the radiator.

## Patentansprüche

1. Elektronische Einrichtung (1), umfassend:
einen Halbleiterchip (11);
ein Substrat (17), das auf einer Unterseite des Halbleiterchips angeordnet ist und einen ersten Bereich (A1) als einen Bereich, in dem der Halbleiterchip montiert ist, und einen zweiten Bereich (A2) als einen Bereich aufweist, in dem ein Leiterelement angeordnet ist, das mindestens eines von einem Schaltungsmuster und einem elektrischen Bauteil (16) einschließt;
einen Kühler (50), der auf einer oberen Seite (11a) des Halbleiterchips angeordnet ist;
ein thermisch leitfähiges Material (31), das zwischen dem Kühler und dem Halbleiterchip vorhanden ist;
ein Dichtungsglied (33), das das wärmeleitfähige Material umgibt; und
ein Isolierabschnitt (15, 115, 215), der das Leiterelement abdeckt, wobei
das wärmeleitfähige Material elektrische Leitfähigkeit aufweist und mindestens zu einem Zeitpunkt eines Betriebs des Halbleiterchips Fließfähigkeit aufweist, und
das Dichtungsglied zwischen einer oberen Oberfläche (15a) des Isolierabschnitts und einer unteren Oberfläche (50c) des Kühlers eingeschoben ist,
wobei eine innere Umfangsoberfläche des Dichtungsglieds dem Halbleiterchip zugewandt ist und eine äußere Umfangsoberfläche des Dichtungsglieds sich innerhalb einer inneren Seite einer äußeren Umfangsoberfläche des Kühlers befindet.

2. Elektronische Einrichtung nach Anspruch 1, ferner umfassend:
eine Versteifung (14), die an dem Substrat befestigt ist, wobei der Isolierabschnitt die Versteifung abdeckt, und
das Dichtungsglied sich zwischen einer oberen Oberfläche (14a) der Versteifung und der unteren Oberfläche des Kühlers befindet.

3. Elektronische Einrichtung nach Anspruch 1, wobei der Isolierabschnitt eine Folie (115, 215) ist, die das Leiterelement abdeckt.

4. Elektronische Einrichtung nach Anspruch 3, wobei der Isolierabschnitt eine erste Folie (215) und eine zweite Folie (225) einschließt, die das Leiterelement abdecken, und die zweite Folie an einer unteren Seite der ersten Folie angeordnet ist.

5. Elektronische Einrichtung nach Anspruch 4, wobei sich ein Material (E2), das die erste Folie an dem Substrat befestigt, und ein Material (E1), das die zweite Folie an dem Substrat befestigt, voneinander unterscheiden.

6. Elektronische Einrichtung nach Anspruch 1 oder 3, wobei ein Abstand von mindestens einem Bauteil einer oberen Oberfläche des Isolierabschnitts zu einer unteren Oberfläche des Kühlers größer als ein Abstand von einer oberen Oberfläche des Halbleiterchips zu der unteren Oberfläche des Kühlers ist.

7. Elektronische Einrichtung nach Anspruch 1 oder 3, wobei eine obere Oberfläche (16a) des elektrischen Bauteils, das in dem zweiten Bereich angeordnet ist, durch den Isolierabschnitt abgedeckt ist.

8. Elektronische Einrichtung nach Anspruch 1 oder 3, ferner umfassend:
eine Versteifung (14), die an dem Substrat befestigt ist, wobei eine Höhe (H2) des mindestens einen Bauteils der oberen Oberfläche des Isolierabschnitts in Bezug auf das Substrat gleich oder kleiner als eine Höhe (H3) einer oberen Oberfläche (14a) der Versteifung in Bezug auf das Substrat ist.

9. Halbleiterbauelement nach Anspruch 3, wobei die Isolierfolie eine obere Wand (115b), die sich an einer oberen Seite (16a) des Leiterelements befindet, und einen ersten Befestigungszielabschnitt (115h) aufweist, der sich zwischen dem Leiterelement und dem Halbleiterchip befindet und direkt oder indirekt an dem Substrat befestigt ist, und
eine Position des ersten Befestigungszielabschnitts niedriger als die obere Wand ist.

10. Elektronische Einrichtung nach Anspruch 1, wobei das Dichtungsglied durch ein Material ausgebildet ist, das eine Änderung einer Dicke des Dichtungsglieds in einer Aufwärts-Abwärts-Richtung zulässt.

11. Elektronische Einrichtung nach Anspruch 1, wobei das Dichtungsglied durch ein Material ausgebildet ist, das sich von dem des Kühlers unterscheidet.

12. Isolierfolie (115, 215) für eine Befestigung an der elektronischen Einrichtung nach Anspruch 1 als der Isolierabschnitt, die Isolierfolie umfassend:
eine Öffnung, die in der Draufsicht in einem zentralen Abschnitt ausgebildet ist, wobei der Halbleiterchip in der Lage ist, in der Öffnung angeordnet zu werden;
einen Gehäuseabschnitt (115a, 215a) zum Abdecken des Leiterelements, wobei der Gehäuseabschnitt eine obere Wand (115b, 215b), die sich an einer oberen Seite (16a) des Leiterelements befindet, und eine innere Wand (115c, 215c) aufweist, die sich an einer inneren Seite der oberen Wand befindet und sich von der oberen Wand nach unten erstreckt; und
einen Befestigungszielabschnitt (115h, 115i), der sich an einer Position befindet, die niedriger als die obere Wand ist, und einen Randabschnitt des Gehäuseabschnitts bildet.

13. Verfahren für eine Herstellung eines Halbleiterbauelements, umfassend:
einen Schritt eines Bereitstellens eines Substrats (17), das einen ersten Bereich (A1) als einen Bereich zum Montieren eines Halbleiterchips (11) und einen zweiten Bereich (A2) als einen Bereich aufweist, in dem ein Leiterelement, das mindestens eines von einem Schaltungsmuster und einem elektrischen Bauteil (16) einschließt, angeordnet ist;
einen Schritt des Abdeckens einer oberen Seite des Leiterelements durch einen Isolierabschnitt (15, 115, 215);
einen Schritt des Anordnens eines Dichtungsglieds (33), das den ersten Bereich umgibt, auf einer oberen Oberfläche des Isolierabschnitts; und
einen Schritt des Anordnens eines Kühlers (50) auf einer oberen Seite (11a) des Halbleiterchips;
wobei das Dichtungsglied zwischen einer oberen Oberfläche (15a) des Isolierabschnitts und einer unteren Oberfläche (50c) des Kühlers eingeschoben ist, und
wobei eine innere Umfangsoberfläche des Dichtungsglieds dem Halbleiterchip zugewandt ist und eine äußere Umfangsoberfläche des Dichtungsglieds sich innerhalb einer inneren Seite einer äußeren Umfangsoberfläche des Kühlers befindet.

## Revendications

1. Appareil électronique (1) comprenant :
une puce semi-conductrice (11) ;
un substrat (17) qui est disposé sur un côté inférieur de la puce semi-conductrice et a une première région (A1) en tant qu'une région dans laquelle la puce semi-conductrice est montée et une seconde région (A2) en tant qu'une région dans laquelle un élément conducteur comportant au moins l'un parmi un motif de circuit et un composant électrique (16) est disposé ;
un radiateur (50) disposé sur un côté supérieur (11a) de la puce semi-conductrice ;
un matériau thermoconducteur (31) présent entre le radiateur et la puce semi-conductrice ;
un élément d'étanchéité (33) entourant le matériau thermoconducteur ; et
une portion isolante (15, 115, 215) recouvrant l'élément conducteur, dans lequel
le matériau thermoconducteur a une conductivité électrique et a une fluidité au moins à un moment de fonctionnement de la puce semi-conductrice, et
l'élément d'étanchéité est pris en sandwich entre une surface supérieure (15a) de la partie isolante et une surface inférieure (50c) du radiateur,
dans lequel une surface périphérique interne de l'élément d'étanchéité fait face à la puce semi-conductrice, et une surface périphérique externe de l'élément d'étanchéité est située à l'intérieur d'un côté interne d'une surface périphérique externe du radiateur.

2. Appareil électronique selon la revendication 1, comprenant en outre :
un raidisseur (14) fixé au substrat, dans lequel la partie isolante recouvre le raidisseur, et
l'élément d'étanchéité est situé entre une surface supérieure (14a) du raidisseur et la surface inférieure du radiateur.

3. Appareil électronique selon la revendication 1, dans lequel la partie isolante est une feuille (115, 215) qui recouvre l'élément conducteur.

4. Appareil électronique selon la revendication 3, dans lequel la partie isolante comporte une première feuille (215) et une seconde feuille (225) qui recouvrent l'élément conducteur, et la seconde feuille est disposée sur un côté inférieur de la première feuille.

5. Appareil électronique selon la revendication 4, dans lequel un matériau (E2) qui fixe la première feuille au substrat et un matériau (E1) qui fixe la seconde feuille au substrat sont différents l'un de l'autre.

6. Appareil électronique selon la revendication 1 ou 3, dans lequel une distance entre au moins une partie d'une surface supérieure de la partie isolante et une surface inférieure du radiateur est supérieure à une distance entre une surface supérieure de la puce semi-conductrice et la surface inférieure du radiateur.

7. Appareil électronique selon la revendication 1 ou 3, dans lequel une surface supérieure (16a) du composant électrique disposé dans la seconde région est recouverte par la partie isolante.

8. Appareil électronique selon la revendication 1 ou 3, comprenant en outre :
un raidisseur (14) fixé au substrat, dans lequel une hauteur (H2) de l'au moins une partie de la surface supérieure de la partie isolante par rapport au substrat est égale ou inférieure à une hauteur (H3) d'une surface supérieure (14a) du raidisseur par rapport au substrat.

9. Dispositif semi-conducteur selon la revendication 3, dans lequel la feuille isolante a une paroi supérieure (115b) située sur un côté supérieur (16a) de l'élément conducteur et une première partie cible de fixation (115h) située entre l'élément conducteur et la puce semi-conductrice et fixée directement ou indirectement au substrat, et
une position de la première partie cible de fixation est plus basse que la paroi supérieure.

10. Appareil électronique selon la revendication 1, dans lequel l'élément d'étanchéité est formé par un matériau qui permet une variation d'épaisseur de l'élément d'étanchéité dans une direction haut-bas.

11. Appareil électronique selon la revendication 1, dans lequel l'élément d'étanchéité est formé par un matériau qui est différent de celui du radiateur.

12. Feuille isolante (115, 215) destinée à être fixée à l'appareil électronique selon la revendication 1 en tant que partie isolante, la feuille isolante comprenant :
une ouverture formée dans une partie centrale vue en plan, la puce semi-conductrice pouvant être disposée dans l'ouverture ;
une partie de boîtier (115a, 215a) pour recouvrir l'élément conducteur, la partie de boîtier ayant une paroi supérieure (115b, 215b) située sur un côté supérieur (16a) de l'élément conducteur et une paroi interne (115c, 215c) qui est située sur une face intérieure de la paroi supérieure et descend de la paroi supérieure ; et
une partie cible de fixation (115h, 115i) située à une position plus basse que la paroi supérieure et constituant une partie de bord de la partie de boîtier.

13. Procédé de fabrication d'un dispositif semi-conducteur comprenant :
une étape de préparation d'un substrat (17) qui a une première région (A1) en tant qu'une région pour le montage d'une puce semi-conductrice (11) et une seconde région (A2) en tant qu'une région dans laquelle un élément conducteur comportant au moins l'un parmi un motif de circuit et un composant électrique (16) est disposé ;
une étape de recouvrement d'un côté supérieur de l'élément conducteur par une partie isolante (15, 115, 215) ;
une étape de disposition d'un élément d'étanchéité (33) entourant la première région sur une surface supérieure de la partie isolante ; et
une étape de disposition d'un radiateur (50) sur un côté supérieur (11a) de la puce semi-conductrice ;
dans lequel l'élément d'étanchéité est pris en sandwich entre une surface supérieure (15a) de la partie isolante et une surface inférieure (50c) du radiateur, et
dans lequel une surface périphérique interne de l'élément d'étanchéité fait face à la puce semi-conductrice, et une surface périphérique externe de l'élément d'étanchéité est située à l'intérieur d'un côté interne d'une surface périphérique externe du radiateur.
